(19) **Europäisches Patentamt European Patent Office Office européen des brevets**

(11) **EP 1 546 742 B1**

(12) **FASCICULE DE BREVET EUROPEEN**

(45) Date de publication et mention de la délivrance du brevet:
**13.03.2013 Bulletin 2013/11**

(21) Numéro de dépôt: **03755599.2**

(22) Date de dépôt: **11.07.2003**

(51) Int Cl.:
*G01R 27/02* *(2006.01)*    *G01R 31/36* *(2006.01)*

(86) Numéro de dépôt international:
**PCT/FR2003/002219**

(87) Numéro de publication internationale:
**WO 2004/008160 (22.01.2004 Gazette 2004/04)**

(54) **PROCEDE DE DETERMINATION DE L'IMPEDANCE D'UN SYSTEME ELECTROCHIMIQUE**

VERFAHREN ZUR BESTIMMUNG DER IMPEDANZ EINES ELEKTROCHEMISCHEN SYSTEMS

METHOD OF DETERMINING THE IMPEDANCE OF AN ELECTROCHEMICAL SYSTEM

(84) Etats contractants désignés:
**AT BE BG CH CY CZ DE DK EE ES FI FR GB GR HU IE IT LI LU MC NL PT RO SE SI SK TR**

(30) Priorité: **15.07.2002 FR 0208897**

(43) Date de publication de la demande:
**29.06.2005 Bulletin 2005/26**

(73) Titulaire: **INSTITUT NATIONAL POLYTECHNIQUE DE GRENOBLE**
**38031 Grenoble (FR)**

(72) Inventeurs:
• **PETRESCU, Bogdan**
  **F-38000 Grenoble (FR)**
• **PETIT, Jean-Pierre**
  **F-38120 Saint-Egrève (FR)**
• **POIGNET, Jean-Claude**
  **F-38400 Saint Martin d'Heres (FR)**

(74) Mandataire: **de Beaumont, Michel et al**
**Cabinet Michel de Beaumont**
**1, rue Champollion**
**38000 Grenoble (FR)**

(56) Documents cités:
**US-A- 5 450 328    US-A- 5 465 287**
**US-A- 6 002 238    US-B1- 6 172 483**

**Description**

Pour la détermination des propriétés et des qualités d'un système électrochimique (tel qu'une pile, une batterie, un système de dépôt électrolytique, un système d'analyse d'un milieu) et la prévision de son fonctionnement futur, l'un des paramètres dont la connaissance est essentielle est l'impédance de ce système.

De façon générale, un système électrochimique comprend, dans un milieu électrolytique, deux électrodes principales - une électrode de travail et une contre-électrode. Une électrode de référence est disposée au voisinage de l'électrode de travail et est utilisée en relation avec celle-ci pour effectuer diverses opérations de mesure ou de régulation. Dans la suite du présent texte les tensions et courants mentionnés correspondent à des mesures effectuées entre une électrode de travail et l'électrode de référence correspondante.

L'impédance d'un système électrochimique correspond au rapport tension sur courant. Il est connu que pour mesurer rapidement la valeur de cette impédance en fonction de la fréquence, il est souhaitable de calculer le rapport des transformées de Fourier discrètes (DFT) de la tension et du courant. Pour cela, on applique entre une électrode de référence et une électrode de travail d'une cellule électrochimique un signal d'excitation de faible amplitude et on mesure à des intervalles de temps égaux $\Delta T$, N valeurs successives $e(n)$ et $i(n)$ de la tension et du courant, avec $1 \leq n \leq N$. L'expression générale des transformées de Fourier discrètes $E(f_m)$ et $I(f_m)$ de la tension et du courant pour une séquence de N points est :

$$E(f_m) = \Delta T \sum_{n=1}^{N} e(n) \exp(-2\pi j f_m n \Delta T) \qquad (1)$$

$$I(f_m) = \Delta T \sum_{n=1}^{N} i(n) \exp(-2\pi j f_m n \Delta T) \qquad (2)$$

où j désigne le nombre complexe dont le carré est -1, N le nombre de points de mesure, $\Delta T$ l'intervalle d'échantillonnage. Le calcul de transformée de Fourier discrète peut être effectué pour N/2 valeurs de fréquence $f_m$, avec $0 \leq m < (N/2)-1$, N étant un nombre pair. Ces N/2 fréquences discrètes sont régulièrement réparties entre 0 et $1/2\Delta T$ ($0...1/m\Delta T...1/2\Delta T$).

L'impédance complexe pour une fréquence $f_m$ donnée est alors égale à :

$$Z(f_m) = E(f_m)/I(f_m). \qquad (3)$$

Les méthodes de mesure d'impédance utilisées dans la pratique, différent principalement par le type de signal d'excitation du système : sinusoïdal, multi-sinusoldal, bruit blanc, etc. Une excitation sinusoïdale est de loin le procédé le plus utilisé car il s'avère être le plus précis. Le procédé consiste à imposer une régulation sinusoïdale à la cellule électrochimique avec un signal de petite amplitude et à enregistrer la réponse de la cellule en courant et en tension. Le rapport des transformées de Fourier de la tension et du courant à la fréquence du sinus donnera la valeur de l'impédance à cette fréquence. Le spectre des fréquences est balayé en modifiant la fréquence d'excitation.

Dans la théorie des systèmes électriques, l'expression de l'impédance (équation (3)) est correcte à condition que le système analysé soit linéaire et stationnaire et que des perturbations ne soient pas apportées par des phénomènes extérieurs au système. Dans le cas des systèmes électrochimiques, le respect de ces conditions impose des précautions particulières. La fonction de transfert d'un système électrochimique est généralement non linéaire mais on peut la considérer comme linéaire sur une petite portion. C'est pour cela qu'on utilise un signal d'excitation de faible amplitude. En conséquence, le rapport signal/bruit diminue et on doit augmenter le temps de mesure, c'est-à-dire le nombre de points de mesure pour éliminer le bruit par une intégration de la réponse. En revanche, l'allongement du temps de mesure pose des problèmes quand à la stationnarité du système électrochimique. Dans beaucoup de cas réels, la condition de stationnarité ne peut pas être remplie. Les causes sont multiples : relaxation du potentiel, relaxation du courant, relaxation des concentrations. Dans ces conditions, si le temps de mesure est suffisamment long pour que l'on ait un bon rapport signal/bruit, le système n'est pas stationnaire pendant la durée de mesure et l'impédance calculée n'a plus grande signification, notamment aux basses fréquences (par exemple inférieures au hertz) où les problèmes de non-stationnarité sont particulièrement aigus.

Divers procédés ont été proposés pour résoudre ce problème de non stationnarité des systèmes électrochimiques, mais aucun n'a donné de solution satisfaisante.

Les brevets (US 6 002 238, US 6 172 483) traitent des mesures d'impédances complexes, mais aucun d'entre eux n'aborde les problèmes liés à des systèmes non stationnaires.

Ainsi, un objet de la présente invention est de prévoir un nouveau procédé de calcul de l'impédance d'un système électrochimique permettant de s'abstraire des erreurs liées à la non stationnarité du système.

Pour atteindre cet objet, la présente invention prévoit un procédé de détermination de l'impédance complexe $Z(f_m)$ d'un système électrochimique non stationnaire, comprenant les étapes suivantes :

mettre le système dans un état de tension choisi et lui appliquer un signal sinusoïdal de fréquence $f_m$,
mesurer immédiatement après des valeurs successives de la tension et du courant à des intervalles de temps réguliers $\Delta T$,
calculer les transformées de Fourier discrètes de la tension ($E(f)$) et du courant ($I(f)$), la transformée de la tension étant calculée pour la seule fréquence $f_m$ du signal sinusoïdal et la transformée du courant étant calculée pour la fréquence $f_m$ et pour deux fréquences adjacentes $f_{m-1}$ et $f_{m+1}$ de part et d'autre de la fréquence $f_m$, et
calculer l'impédance selon la formule suivante :

$$Z(f_m) = E(f_m)/I*(f_m)$$

où I* désigne un courant corrigé tel que :

$$Re[I*(f_m)] = Re[I(f_m)] - \{Re[I(f_{m+1})]+Re[I(f_{m-1})]\}/2$$

$$Im[I*(f_m)] = Im[I(f_m)] - \{Im[I(f_{m+1})]+Im[I(f_{m-1})]\}/2.$$

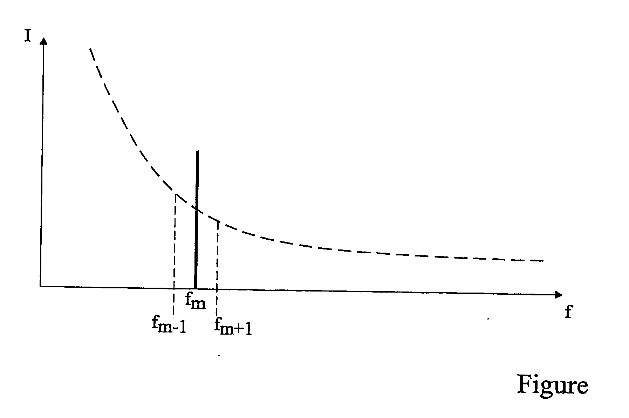

Un mode de réalisation particulier de la présente invention sera exposé à titre non-limitatif en relation avec la figure jointe qui représente le spectre d'amplitude en fonction de la fréquence d'un système électrochimique soumis à une excitation sinusoïdale de faible amplitude et à un échelon de tension.

Tout d'abord, on notera que, comme le potentiel appliqué est imposé par l'instrument d'analyse, la non stationnarité du système ne peut se manifester que par des fluctuations de courant.

La présente invention se base sur l'analyse du comportement d'un système électrochimique soumis à un échelon de tension. La DFT de la réponse en courant traduit pour l'essentiel des phénomènes de relaxation et donc l'effet de la non stationnarité du système. Comme le représente la courbe en pointillés sur la figure unique, le spectre en amplitude I du module de la DFT du courant présente habituellement une forte réponse à basse fréquence à des échelons de tension.

Par contre, la réponse à une excitation sinusoïdale de fréquence $f_m$ d'un système stationnaire se traduit par une raie unique à la fréquence $f_m$. En pratique, cette réponse correspond d'une part à la réaction du système à l'excitation à la fréquence $f_m$, d'autre part à la contribution des effets de relaxation.

L'avantage de l'utilisation de la transformée de Fourier est que le spectre monofréquence lié à l'excitation sinusoïdale est superposé au spectre lié à l'échelon de tension.

Selon la présente invention, une fois les considérations ci-dessus prises en compte, on propose de soustraire de la réponse en intensité à la fréquence $f_m$ la contribution due aux relaxations, évaluée à partir de l'analyse de la DFT aux fréquences adjacentes à $f_m$. En effet, la transformée de Fourier pour des fréquences $f_{m-1}$ et $f_{m+1}$ du système ne correspondra qu'aux phénomènes de non stationnarité et on considérera que la valeur de l'amplitude liée aux non stationnarités pour une fréquence $f_m$ est la moyenne des valeurs pour les deux fréquences adjacentes.

Ainsi, la présente invention propose :

- de placer un système électrochimique dans un état de tension choisi et de lui appliquer une excitation sinusoïdale monofréquence de faible amplitude,
- de mesurer, sans attendre la stabilisation du système, l'amplitude du courant et de la tension à des intervalles de temps réguliers immédiatement après l'application de la tension tandis que l'excitation sinusoïdale est appliquée, et
- de calculer d'une part la transformée de Fourier discrète de la tension pour la fréquence $f_m$ de l'excitation et d'autre part la DFT du courant pour la valeur $f_m$ et pour deux valeurs de fréquence $f_{m-1}$ et $f_{m+1}$ adjacentes à la fréquence $f_m$, et
- de calculer la valeur de l'impédance complexe à la fréquence $f_m$ à partir de la valeur de la TFD de la tension pour la fréquence $f_m$ et d'une valeur corrigée de la TFD du courant tenant compte des TFD calculées pour les fréquences $f_{m-1}$, $f_m$ et $f_{m+1}$.

On calculera l'amplitude corrigée I* de la transformée de Fourier discrète du courant en valeur réelle et en valeur imaginaire par les deux équations suivantes :

$$\mathrm{Re}[I*(f_m)] = \mathrm{Re}[I(f_m)] - \{\mathrm{Re}[I(f_{m+1})]+\mathrm{Re}[I(f_{m-1})]\}/2$$

$$\mathrm{Im}[I*(f_m)] = \mathrm{Im}[I(f_m)] - \{\mathrm{Im}[I(f_{m+1})]+\mathrm{Im}[I(f_{m-1})]\}/2$$

La valeur de l'impédance corrigée des effets de non stationnarité est alors :

$$Z(f_m) = E(f_m)/I*(f_m)$$

avec

$$I*(f_m) = \mathrm{Re}[I*(f_m)] + j\mathrm{Im}[I*(f_m)]$$

Dès le relevé des points effectué pour la fréquence $f_m$, on pourra appliquer un signal sinusoïdal à une nouvelle fréquence et effectuer un nouveau relevé, et ainsi de suite.

Un avantage du présent procédé est qu'il rend possible une analyse correcte d'impédance sur des systèmes électrochimiques non stationnaires notamment aux très basses fréquences. En même temps, un gain de temps considérable est obtenu pour des systèmes qui se stabilisent lentement car avec la correction selon l'invention, il n'est plus nécessaire d'attendre la stabilisation après une mise sous tension du système pour démarrer une analyse d'impédance.

## Revendications

1. Procédé de détermination de l'impédance complexe $Z(f_m)$ d'un système électrochimique non stationnaire, **caractérisé en ce qu'**il comprend les étapes suivantes :

mettre le système dans un état de tension choisi et lui appliquer un signal sinusoïdal de fréquence $f_m$, mesurer immédiatement après des valeurs successives de la tension et du courant à des intervalles de temps réguliers $\Delta T$,
calculer les transformées de Fourier discrètes de la tension (E(f)) et du courant (I(f)), la transformée de la tension étant calculée pour la seule fréquence $f_m$ du signal sinusoïdal et la transformée du courant étant calculée pour la fréquence $f_m$ et pour deux fréquences adjacentes $f_{m-1}$ et $f_{m+1}$ de part et d'autre de la fréquence $f_m$, et calculer l'impédance selon la formule suivante :

$$Z(f_m) = E(f_m)/I*(f_m)$$

où I* désigne un courant corrigé tel que :

$$\mathrm{Re}[I*(f_m)] = \mathrm{Re}[I(f_m)] - \{\mathrm{Re}[I(f_{m+1})]+\mathrm{Re}[I(f_{m-1})]\}/2$$

$$\mathrm{Im}[I*(f_m)] = \mathrm{Im}[I(f_m)] - \{\mathrm{Im}[I(f_{m+1})]+\mathrm{Im}[I(f_{m-1})]\}/2.$$

2. Procédé selon la revendication 1, **caractérisé en ce qu'**il est répété pour une succession de fréquences d'excitation.

## Claims

1. A method for determining the complex impedance $Z(f_m)$ of a non-stationary electrochemical system, **characterized**

**in that** it comprises the steps of:

setting the system to a selected voltage state and applying a sinusoidal signal of frequency $f_m$ thereto, measuring, immediately after, successive values of the voltage and of the current at regular time intervals $\Delta T$, calculating the discrete Fourier transforms of the voltage ($E(f)$) and of the current ($I(f)$), the voltage transform being calculated for the sole frequency $f_m$ of the sinusoidal signal and the current transform being calculated for frequency $f_m$ and for two adjacent frequencies $f_{m-1}$ and $f_{m+1}$ on either side of frequency $f_m$, and calculating the impedance according to the following formula:

$$Z(f_m) = E(f_m)/I^*(f_m)$$

where I* designates a corrected current such that:

$$Re[I^*(f_m)] = Re[I(f_m)] - \{Re[I(f_{m+1})]+Re[I(f_{m-1})]\}/2$$

$$Im[I^*(f_m)] = Im[I(f_m)] - \{Im[I(f_{m+1})]+Im[I(f_{m-1})]\}/2.$$

2. The method of claim 1, **characterized in that** it is repeated for a succession of excitation frequencies.

**Patentansprüche**

1. Ein Verfahren zur Bestimmung der komplexen Impedanz $Z(f_m)$ eines nicht-stationären elektrochemischen Systems, **dadurch gekennzeichnet, dass** die folgenden Schritte vorgesehen sind:

Einstellen des Systems auf einen ausgewählten Spannungszustand und Anlegen eines sinusförmigen Signals der Frequenz $f_m$ daran, Messen, unmittelbar danach, auf einanderfolgende Werte der Spannung und des Stromes zu regelmäßigen Zeitintervallen $\Delta T$,
Berechnen der diskreten Fourier-Transformationen der Spannung ($E(f)$) und des Stromes ($I(f)$), wobei die Spannungstransformation berechnet wird für die einzige Frequenz $f_m$ des sinusförmigen Signals und die Stromtransformation berechnet wird für die Frequenz $f_m$ und für zwei benachbarte Frequenzen $f_{m-1}$ und $f_{m+1}$ auf jeder Seite der Frequenz $f_m$, und
Berechnen der Impedanz gemäß der folgenden Formel:

$$Z(f_m) = E(f_m)/I^*(f_m),$$

wobei I* einen korrigierten Strom bezeichnet, derart dass

$$Re[I^*(f_m)] = Re[I(f_m)] - \{Re[I(f_{m+1})]+Re[I(f_{m-1})]\}/2$$

$$Im[I^*(f_m)] = Im[I(f_m)] - \{Im[I(f_{m+1})]+Im[I(f_{m-1})]\}/2.$$

2. Verfahren nach Anspruch 1, **dadurch gekennzeichnet, dass** es für eine Folge von Erregungsfrequenzen wiederholt wird.

Figure

## RÉFÉRENCES CITÉES DANS LA DESCRIPTION

**Documents brevets cités dans la description**

- US 6002238 A
- US 6172483 B